# EUROPEAN PATENT SPECIFICATION

(11) **EP 2 762 286 B1**
(45) Date of publication and mention of the grant of the patent: **01.07.2015**
(21) Application number: 13153528.8
(22) Date of filing: 31.01.2013
(51) Int. Cl.: B28D 5/00

(54) **Dicing method**
Zerteilungsverfahren
Procédé de découpage en dés

(43) Date of publication of application: 06.08.2014
(73) Proprietor: ams AG, 8141 Unterpremstätten (AT)
(72) Inventor: Draxler, Walter, 8570 Voitsberg (AT)
(74) Representative: Epping - Hermann - Fischer

(56) References cited:
- GB-A- 2 459 669
- JP-A- S5 836 939
- US-A1- 2005 277 270
- US-A1- 2007 272 666
- US-A1- 2007 272 668
- US-A1- 2008 277 806
- US-A1- 2010 081 255
- US-A1- 2010 133 659

## Description

Semiconductor wafers are usually diced by sawing or laser cutting. Chips that are obtained from the wafer by sawing usually show chipping on both sides of the sawing line, and cracks are liable to occur.

US 8,058,103 B2 discloses a method for cutting a semiconductor wafer by irradiation with laser light, which generates a starting point region for cutting within the wafer. By attaching an expansion film to the rear face and expanding the film, a fracture is generated from the starting point region to the front and rear surfaces of the wafer. In a variant of this method the fracture is generated by a means for applying stress, such as a knife edge that is pressed against the rear face of the silicon wafer in the direction along the starting point region.

US 2008/027780-6 A1 discloses a dicing method for a wafer comprising integrated circuit regions separated by dicing lanes at a front surface. A trench aligned with the dicing lanes is formed in the rear surface, which can be done by laser ablation. The wafer is cut by means of a dicing blade from the front to the rear surface or vice versa.

US 2007/0272666 A1 discloses a dicing method for a silicon substrate comprising layers forming electronic circuits separated from each other by scribing streets. A kerf is produced in the streets by ablating some of the layers with a beam of laser pulses. The silicon substrate may be substantially transparent to the wavelengths of the laser pulses to prevent absorption of energy and undesired heating.

US 2007/0272668 A1 discloses a method according to the preamble of independent claim 1 and a dicing method for a silicon substrate comprising layers forming active device areas separated from each other by scribing streets. A kerf is produced with a laser beam ablating the layers to the top surface of the substrate.

US 2010/0081255 A1 discloses methods for reducing defects through selective laser scribing. Controlled energy density of a series of laser pulses enhances and normalizes a remaining scribe structure prior to singulation.

GB 2459669 A discloses methods of wafer dicing by means of laser scribing, which is used to remove layers from a surface of dice lanes before sawing. A mode-locked laser is preferred to allow a change of laser parameters as a function of position on the wafer in order to adapt the scribing process to different layer materials.

US 2010/0133659 A1 discloses methods for wafer dicing by laser scribing. A laser beam is directed to scribe regions to form a groove. A rotating blade is inserted into the groove to cut the substrate.

US 2005/0277270 A1 discloses methods for wafer dicing by laser scribing. An inclined laser beam is used to form grooves along dicing streets. A cutting machine comprising a cutting blade is used to cut the wafer along the laser grooves.

JP 58-036939 discloses a method of cutting a wafer with a dicing blade using auxiliary laser irradiation. The mechanical cut of the blade following the laser light is applied almost simultaneously with the laser cut.

It is an object of the present invention to disclose a dicing method, in particular a method of dicing a semiconductor wafer, that allows to reduce the width of the saw street.

This object is achieved with the method according to claim 1. Variants derive from the dependent claims.

The dicing method comprises providing a substrate, especially a semiconductor wafer, applying a laser cut to the substrate, and subsequently applying a saw to divide the substrate from a main surface. The laser cut is directed to a partial volume of the substrate, the partial volume being opposite the main surface.

In a variant of the method the laser cut is directed to lateral boundaries of a saw street.

In a further variant the laser cut allows the substrate to be divided with the saw not completely penetrating the substrate.

In a further variant the partial volume may especially amount to more than 5 % and less than 40 % , or more specifically to more than 10 % and less than 30 % of the total volume of the substrate.

In a further variant the substrate is a semiconductor wafer. The partial volume may especially include a layer of integrated components.

In further variants the substrate comprises glass or ceramics or is provided for microelectromechanical systems.

The following is a detailed description of examples of the method.
- Figure 1: is a cross section of a substrate that is to be diced during the application of laser light.
- Figure 2: is a cross section of the substrate during the application of a saw.
- Figure 3: is a cross section according to Figure 1 for a variant of the method.
- Figure 4: is a cross section according to Figure 2 for the variant of the method.

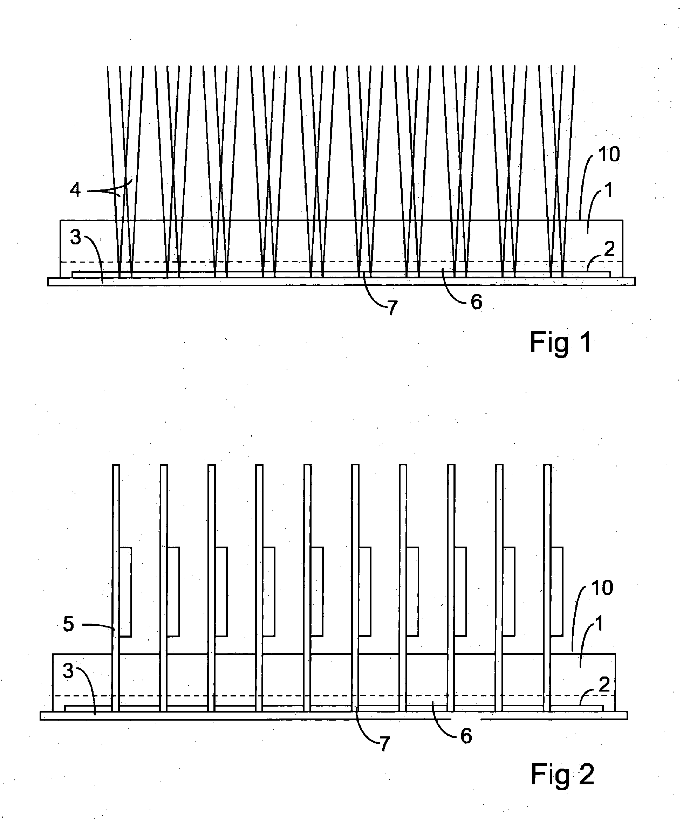

Figure 1 is a cross section of a substrate 1 that is to be diced from an outer surface, which is here referred to as the main surface 10. The substrate 1 may be a semiconductor wafer, for instance, a glass substrate, a ceramics substrate or a substrate that is provided for microelectromechanical systems. The method may also be applied to other kinds of substrates that are diced into smaller components. In the following the method is described for a semiconductor wafer representing the substrate 1. The method can similarly be applied to other substrates.

The wafer 1 is typically diced into chips at the end of a process in which integrated components are produced in the wafer. Figure 1 shows an example in which the main surface 10 is opposite a layer of integrated components 2. This arrangement is preferred, but the wafer 1 may instead be diced from the surface comprising the integrated components. In the following the method is described for an example in which the integrated components are opposite the main surface 10. A tape or foil 3, especially an adhesive tape or foil 3, may be applied to the wafer 1 opposite the main surface 10 to facilitate the handling.

A laser cut 4 is performed from the main surface 10 into the wafer 1. The laser beams shown in Figure 1 are preferably focused to regions within a partial volume 6 of the wafer 1 opposite the main surface 10. In the example shown in Figure 1 the laser cut 4 is directed to the lateral boundaries of a saw street 7. When the lateral boundaries of the saw street 7 are thus prepared, the subsequent cutting by means of a saw yields sufficiently smooth cutting faces forming a barrier where cracking or chipping will be stopped. Even if the wafer 1 has a thickness of more than 100 µm, the method allows a very small width of the saw street 7 of typically about 30 µm, for example, because the laser cut 4 is sufficiently precise and allows a gap of 30 µm between the laser lines.

Figure 2 is a cross section of the wafer 1 during the application of a saw 5. The blade of the saw 5 divides the wafer 1 into chips. In this variant of the method the blade of the saw 5 completely penetrates the wafer 1. Chipping or cracking is prevented by the preparation of the saw cut through the partial volume 6, where cuts have already been applied to the boundaries of the saw street 7 by the preceding laser cut 4. The partial volume 6 may typically comprise a range from 5 % to 40 % or, more specifically, from 10 % to 30 % of the wafer thickness.

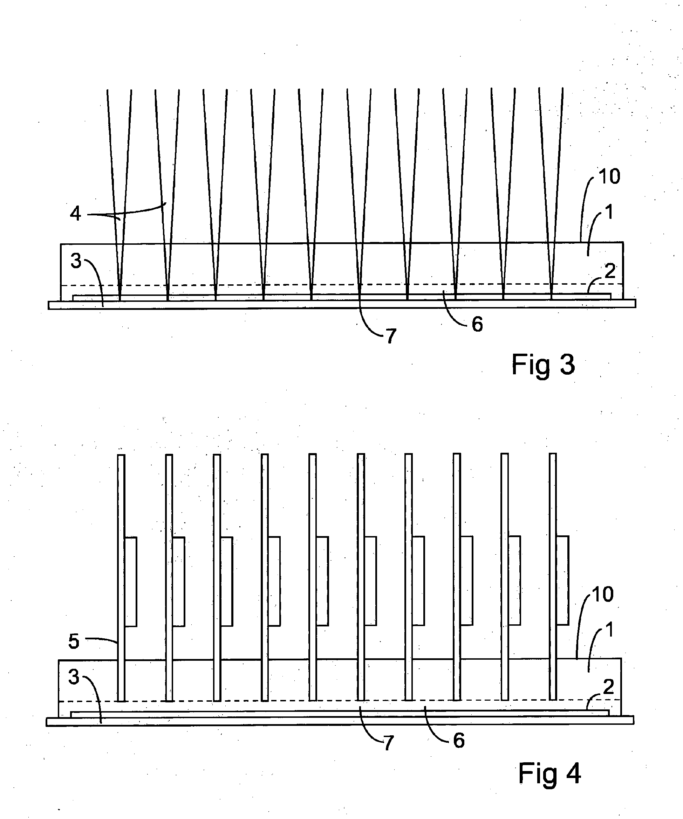

Figure 3 is a cross section according to Figure 1 for a variant of the method, which uses the laser cut 4 as a partial cut through a partial volume 6 comprising a range from 5 % to 40 % or, more specifically, from 10 % to 30 % of the wafer thickness. The laser cut 4 is therefore applied inside the saw street 7 and partially divides the wafer 1 by cuts that are applied in the partial volume 6. If the wafer 1 has a thickness of 200 µm, for example, the partial laser cut 4 will preferably divide a portion of the wafer 1 that is about 10 µm to 80 µm or, more specifically, about 20 µm to 60 µm thick.

Figure 4 is a cross section according to Figure 2 for the variant according to Figure 3 and shows the saw 5 applied to divide the wafer 1 into chips. The cut of the saw 5 may be restricted to about 60 % to 95 % or, more specifically, about 70 % to 90 % of the wafer thickness, because a cut has already been effected in the partial volume 6 by the preceding laser cut 4.

The described method allows a very small width of the saw streets and is in particular advantageous for wafers that are more than 100 µm thick. The risk of chipping and cracking during the sawing process is essentially reduced by the preceding laser cut. A much higher sawing speed than in conventional dicing processes can be achieved with the combination of laser cut and mechanical sawing according to the described method.

### List of reference numerals

- 1: substrate
- 2: layer of integrated components
- 3: tape or foil
- 4: laser cut
- 5: saw
- 6: partial volume
- 7: saw street
- 10: main surface

## Claims

1. Dicing method, comprising:
- providing a substrate (1),
- applying a saw (5) to divide the substrate (1) from a main surface (10), and
- performing a laser cut (4) of the substrate (1) before the saw (5) is applied,
**characterized in that**
- the laser cut (4) is performed from the main surface (10) into the substrate (1) and is focused to regions within a partial volume (6) of the substrate (1), the partial volume (6) being opposite the main surface (10).

2. The method of claim 1, wherein the laser cut (4) is directed to lateral boundaries of a saw street (7).

3. The method of claim 1, wherein the laser cut (4) allows the substrate (1) to be divided with the saw (5) not completely penetrating the substrate (1).

4. The method of claim 1, wherein the partial volume (6) amounts to more than 5 % and less than 40 % of the total volume of the substrate (1).

5. The method of claim 1, wherein the partial volume (6) amounts to more than 10 % and less than 30 % of the total volume of the substrate (1).

6. The method of one of claims 1 to 5, wherein the substrate (1) is a semiconductor wafer.

7. The method of one of claims 1 to 5, wherein the substrate (1) is a semiconductor wafer, and the partial volume (6) includes a layer of integrated components (2).

8. The method of one of claims 1 to 5, wherein the substrate (1) comprises glass or ceramics.

9. The method of one of claims 1 to 5, wherein the substrate (1) is provided for microelectromechanical systems.

## Patentansprüche

1. Dicing-Verfahren, Folgendes umfassend:
- Bereitstellen eines Substrats (1),
- Anlegen einer Säge (5), um das Substrat (1) ausgehend von einer Hauptfläche (10) zu zerteilen, und
- Durchführen eines Laserschnitts (4) des Substrats (1), bevor die Säge (5) angelegt wird,
**dadurch gekennzeichnet, dass**
- der Laserschnitt (4) ausgehend von der Hauptfläche (10) in das Substrat (1) hinein erfolgt und auf Bereiche in einem Teilvolumen (6) des Substrats (1) konzentriert wird, wobei das Teilvolumen (6) der Hauptfläche (10) entgegengesetzt ist.

2. Verfahren nach Anspruch 1, wobei der Laserschnitt (4) zu seitlichen Grenzen eines Ritzrahmens (7) hin gerichtet wird.

3. Verfahren nach Anspruch 1, wobei es der Laserschnitt (4) ermöglicht, das Substrat (1) mit der Säge (5), das Substrat (1) nicht gänzlich durchdringend zu zerteilen.

4. Verfahren nach Anspruch 1, wobei das Teilvolumen (6) mehr als 5% und weniger als 40% des Gesamtvolumens des Substrats (1) ausmacht.

5. Verfahren nach Anspruch 1, wobei das Teilvolumen (6) mehr als 10% und weniger als 30% des Gesamtvolumens des Substrats (1) ausmacht.

6. Verfahren nach einem der Ansprüche 1 bis 5, wobei es sich bei dem Substrat (1) um einen Halbleiterwafer handelt.

7. Verfahren nach einem der Ansprüche 1 bis 5, wobei es sich bei dem Substrat (1) um einen Halbleiterwafer handelt und das Teilvolumen (6) eine Schicht von integrierten Komponenten (2) enthält.

8. Verfahren nach einem der Ansprüche 1 bis 5, wobei das Substrat (1) Glas oder Keramik aufweist.

9. Verfahren nach einem der Ansprüche 1 bis 5, wobei das Substrat (1) für mikroelektromechanische Systeme vorgesehen ist.

## Revendications

1. Procédé de découpe en puces, comprenant:
- la fourniture d'un substrat (1),
- l'application d'une scie (5) pour diviser le substrat (1) à partir d'une surface principale (10), et
- la réalisation d'une coupe au laser (4) du substrat (1) avant que la scie (5) soit appliquée,
**caractérisé en ce que**
- la coupe au laser (4) est effectuée à partir de la surface principale (10) dans le substrat (1) et se concentre sur des zones situées au sein d'un volume partiel (6) du substrat (1), le volume partiel (6) étant opposé à la surface principale (10).

2. Le procédé de la revendication 1, dans lequel la coupe au laser (4) est dirigée vers des bordures latérales d'un trait de scie (7).

3. Le procédé de la revendication 1, dans lequel la coupe au laser (4) permet au substrat (1) d'être divisé avec la scie (5) ne pénétrant pas complètement dans le substrat (1).

4. Le procédé de la revendication 1, dans lequel le volume partiel (6) se monte à plus de 5 % et moins de 40 % du volume total du substrat (1).

5. Le procédé de la revendication 1, dans lequel le volume partiel (6) se monte à plus de 10 % et moins de 30 % du volume total du substrat (1).

6. Le procédé de l'une des revendications 1 à 5, dans lequel le substrat (1) est une plaquette en semiconducteur.

7. Le procédé de l'une des revendications 1 à 5, dans lequel le substrat (1) est une plaquette en semiconducteur, et le volume partiel (6) inclut une couche de composants intégrés (2).

8. Le procédé de l'une des revendications 1 à 5, dans lequel le substrat (1) comprend du verre ou de la céramique.

9. Le procédé de l'une des revendications 1 à 5, dans lequel le substrat (1) est prévu pour des systèmes microélectromécaniques.
